# EUROPÄISCHE PATENTSCHRIFT

(11) **EP 3 224 386 B1**
(45) Veröffentlichungstag und Bekanntmachung des Hinweises auf die Patenterteilung: **30.12.2020**
(21) Anmeldenummer: 15797928.7
(22) Anmeldetag: 13.11.2015
(51) Int. Cl.: C23C 16/458, H01L 21/687

(54) **SUBSTRATHALTEVORRICHTUNG**
SUBSTRATE HOLDER
SUPPORT DE SUBSTRATS

(30) Priorität: 28.11.2014 DE 102014117520; 26.10.2015 DE 102015118215
(43) Veröffentlichungstag der Anmeldung: 04.10.2017
(73) Patentinhaber: Aixtron SE, 52134 Herzogenrath (DE)
(72) Erfinder: SUFAN, Eduardo Osman Piniero, 47533 Kleve (DE); CLAESSENS, Daniel, 52072 Aachen (DE); BOYD, Adam, B-4720 Kelmis (BE)
(74) Vertreter: Grundmann, Dirk
(86) Internationale Anmeldenummer: PCT/EP2015/076562
(87) Internationale Veröffentlichungsnummer: WO 2016/083162

(56) Entgegenhaltungen:
- US-A1- 2003 209 326
- US-A1- 2013 143 393
- US-A1- 2014 287 142

## Beschreibung

### Gebiet der Technik

Die Erfindung betrifft eine Vorrichtung zur Halterung mindestens eines Substrates zur Verwendung in einer Prozesskammer eines CVD- oder PVD-Reaktors, mit einer flachen Oberseite, auf der sich zumindest ein Lagerplatz für das mindestens eine Substrat befindet, wobei eine der Umrisskontur des Substrates entsprechende Umrisskonturlinie von Positionierflanken zur lagefixierenden Anlage jeweils eines Abschnitts eines Randes des Substrates flankiert ist, und mit von einer von der Umrisskonturlinie umgebenen Lagerplatzbodenfläche des Lagerplatzes abragenden Tragvorsprüngen, die gegenüber der Lagerplatzbodenfläche erhabene Anlageflächen aufweisen, auf die das Substrat auflegbar ist.

### Stand der Technik

Aus der US 2013/0143393 A1 ist eine Vorrichtung zur Halterung eines Substrates in einem CVD-Reaktor bekannt, bei der von einer Lagerplatzbodenfläche eines Lagerplatzes eines Substrates Tragvorsprünge abragen, die einer den Tragvorsprung umgebenden Vertiefung entspringen, wobei der Vorsprung einen kreisförmigen oder elliptischen Querschnitt und die Vertiefung einen halbkreisförmigen oder halbelliptischen Querschnitt aufweisen kann.

Eine Vorrichtung dieser Art ist aus der US 5,645,646 vorbekannt. Die Druckschrift offenbart einen Suszeptor mit einem Lagerplatz zur Aufnahme eines Substrates, wobei der Lagerplatz von einer Positionierflanke begrenzt ist, die eine Umrisskonturlinie umgibt, die der Umrisskontur eines Substrates entspricht, so dass das Substrat mit einem geringen Abstand seines Randes von der Positionierflanke vom Lagerplatz aufgenommen werden kann. Von einer Lagerplatzbodenfläche des Lagerplatzes ragen mehrere Tragvorsprünge ab, auf denen sich ein dem Rand des Substrates naher Bereich der Unterseite des Substrates abstützt, so dass das Substrat hohl über der Lagerplatzbodenfläche liegt.

Die DE 10 2012108 986 A1 beschreibt einen Substrathalter einer CVD-Vorrichtung, der aus einer flachen Scheibe mit einer Oberseite und einer Unterseite besteht. Die Oberseite weist taschenartige Strukturen auf, die Lagerplätze für jeweils ein kreisrundes Substrat aufweisen. Randabschnitte von Sockeln der Oberseite bilden Positionierflanken zur Lagefixierung jeweils eines einer Vielzahl von auf der Oberseite des Substrathalters angeordneten Substraten. Der Rand der Substrate ruht auf vereinzelten Tragvorsprüngen, die an die Positionierflanke angrenzen. Der in die Lagerfläche des Lagerplatzes hineinragende Abschnitt des Tragvorsprungs ist von einem Graben umgeben. Die Sockel haben einen dreieckigen Grundriss und sind in der Lage, die Substrate in einer hexagonalen Anordnung zu positionieren.

Einen Substrathalter mit Lagerplätzen und im Bereich der Lagerflächen der Lagerplätze angeordnete vertikale Strukturen zur Punktauflage des Substrates zeigen darüber hinaus auch die US 6,840,767 B2 und US 2013/0109192 A1.

Die Aufgabe eines gattungsgemäßen Substrathalters ist seine Verwendung als Suszeptor in einer CVD- oder PVD-Beschichtungseinrichtung. Derartige Beschichtungseinrichtungen besitzen einen Reaktor mit einer Prozesskammer, deren Boden von der Oberseite des Substrathalters gebildet ist. Der Substrathalter wird gekühlt oder von unten auf eine Prozesstemperatur aufgeheizt. Durch ein Gaseinlassorgan werden Prozessgase in die Prozesskammer eingeleitet. Bei einem CVD-Reaktor reagieren die Prozessgase in der Gasphase oberhalb des Suszeptors oder auf der Oberfläche des Suszeptors beziehungsweise auf den Oberflächen der auf dem Suszeptor aufliegenden Substrate. Es finden Oberflächenreaktionen statt. Dabei bildet sich eine Schicht auf der Substratoberfläche. Die Qualität und die Schichtdicke der dort abgeschiedenen Schicht hängen in erheblichem Maße von der Oberflächentemperatur des Substrates ab. Es ist deshalb wünschenswert, einen minimalen lateralen Oberflächentemperaturgradienten auf den Substraten zu realisieren. Hierzu wird bei einem gattungsgemäßen Substrathalter das Substrat lediglich punktweise unterstützt. Es liegt auf einem Lagerplatz, der eine Umrisskonturlinie aufweist, die nur wenig außerhalb der vom Substrat beanspruchten Fläche liegt. Die Positionierflanken verlaufen mit geringem Abstand entlang des Randes des Substrates, um so das Substrat auf dem Lagerplatz lagezufixieren. Lediglich der Rand des Substrates liegt auf Tragvorsprüngen auf. Über diese Tragvorsprünge findet eine Kontakt-Wärmeübertragung vom Suszeptor zum Substrat statt. Der überwiegende Flächenbereich des Substrates liegt ansonsten hohl, d.h. mit einem vertikalen Abstand oberhalb der Bodenfläche des Lagerplatzes, so dass die Wärmeübertragung von der Bodenfläche des Lagerplatzes zur Unterseite des Substrates im Wesentlichen über Wärmestrahlung oder über Konvektion über das sich in der Prozesskammer befindliche Trägergas stattfindet. Es ist ein Nachteil, dass sich das Substrat im Bereich seiner Auflagepunkte auf den Tragvorsprüngen geringfügig stärker aufheizt als im restlichen Bereich. Die Oberflächentemperatur des Substrates ist somit im Bereich der Auflagepunkte geringfügig höher als im übrigen Bereich des Substrates.

### Zusammenfassung der Erfindung

Der Erfindung liegt die Aufgabe zugrunde, Maßnahmen zu ergreifen, mit denen die Temperaturhomogenität der Oberflächentemperatur des Substrates verbessert werden kann.

Gelöst wird die Aufgabe durch die in den Ansprüchen angegebene Erfindung.

Zunächst und im Wesentlichen wird vorgeschlagen, dass die Tragvorsprünge einer Vertiefung entspringen. Die Vertiefung kann einen ebenen Boden oder einen gewölbten Boden besitzen. Der Boden beziehungsweise der Wölbungsscheitel der Vertiefung definiert ein Vertiefungsniveau. Bevorzugt sind mindestens drei Tragvorsprünge im Bereich des Lagerplatzes angeordnet, wobei jeder Tragvorsprung einer Vertiefung entspringt und alle Vertiefungsböden beziehungsweise Vertiefungsscheitel auf demselben Vertiefungsniveau liegen. Die Vertiefung grenzt mit einem Rand an die Lagerplatzbodenfläche an, die auf einem Bodenflächenniveau verläuft. Die Lagerplatzbodenfläche kann eine Ebene sein. Der Tragvorsprung kann mit einer steilen Wand, gewissermaßen zylinderartig, der Vertiefung entspringen. Bevorzugt ist der Tragvorsprung jedoch als Wölbung ausgebildet. Die Auflagefläche des Tragvorsprungs oder die Auflageflächen der mehreren Tragvorsprünge liegt beziehungsweise liegen in einem Substratauflageniveau. Das Bodenflächenniveau hat einen geringeren vertikalen Abstand zum Substratauflageniveau als das Vertiefungsniveau. Der mindestens eine Tragvorsprung kann von einer ringförmigen Vertiefung umgeben sein. Es liegt bevorzugt jeweils nur ein Tragvorsprung in einer Vertiefung. Dabei kann vorgesehen sein, dass der Tragvorsprung und die ihn umgebene Vertiefung vollständig innerhalb der Umrisskonturlinie liegt. Die Umrisskonturlinie fasst somit auch die Ränder der Vertiefungen ein. Es ist aber auch vorgesehen, dass die Tragvorsprünge oder zumindest einige der Tragvorsprünge und insbesondere deren Auflageflächen von der Umrisskonturlinie gekreuzt werden. Die Umrisskonturlinie kreuzt dann auch die Vertiefung. Der Rand der Vertiefung kann von einer Positionierflanke beabstandet sein. Entlang der Positionierflanke kann sich eine als Graben ausgebildete Vertiefung beziehungsweise Ausnehmung erstrecken. Die den Tragvorsprung umgebende Vertiefung kann Teil dieses Grabens sein. Der Rand der Vertiefung kann somit entweder an die Positionierflanke angrenzen oder von der Positionierflanke entfernt sein. In einer Weiterbildung der Erfindung kann sich der Tragvorsprung auch im Bereich zwischen zwei benachbarten Sockeln befinden. Ein derartiger Tragvorsprung kann in der Lage sein, die Randkanten zweier benachbarter Substrate zu tragen. Der Tragvorsprung ist dann funktionell zwei benachbarten Lagerplätzen zugeordnet, wobei die den beiden Lagerplätzen zugeordneten Umrisskonturlinien jeweils dieselbe Auflagefläche kreuzen. Auch ein derartiger Tragvorsprung wird von einer Vertiefung umgeben, wobei die Vertiefung eine ovale Ringform besitzen kann und die Auflagefläche länglich ausgestaltet ist, wobei sich eine Längserstreckungsrichtung der Auflagefläche in Richtung eines Zentrums einer kreisförmigen Umrisskonturlinie erstreckt. Erfindungsgemäß geht die Lagerplatzbodenfläche kantenfrei in eine gerundete Wandung der Vertiefung über. Die gerundete Wandung der Vertiefung kann eine Querschnittskontur aufweisen, die von sich aneinander anschließenden Kreisbogenabschnitten ausgebildet ist. Die Vertiefung besitzt eine ringförmige Scheitellinie oder Scheitelfläche, die knickstellenfrei unter Ausbildung einer Querschnittsverrundung in die Außenwandung des Tragvorsprungs übergeht. Die Wandung des Tragvorsprungs geht auch knickstellenfrei ebenfalls unter Ausbildung einer Querschnittsverrundung in die ebene Auflagefläche über. In einer Weiterbildung der Erfindung wird vorgeschlagen, dass die Tragvorsprünge nicht unmittelbar an die Positionierflanken angrenzen, sondern dass die Tragvorsprünge ringsum von einem Graben umgeben sind. Die Positionierflanken sind in Erstreckungsrichtung der Umrisskonturlinie von den Tragvorsprüngen beabstandet. Dies hat zur Folge, dass der Wärmefluss von den Positionierflanken zu den Tragvorsprüngen vermindert ist. Dies ist insbesondere dann von Vorteil, wenn die Positionierflanken die Seitenwände von Sockeln sind, die der Oberseitenebene des Substrathalters entspringen. Zwischen zwei unmittelbar benachbarten Positionierflanken, die sich entlang einer Umrisskonturlinie des Lagerplatzes erstrecken, wird bevorzugt eine Nische ausgebildet. Die Nische kann eine Nischenwand aufweisen, die sich an der von einer Wand ausgebildeten Positionierflanke anschließt. Diese Wand, die auf dem Rand der Nische verläuft, erstreckt sich bevorzugt auf einer Halbkreisbogenlinie. Zwischen der Halbkreisbogenlinie der Nischenwandung und einer entlang eines Halbkreisbogens sich erstreckenden Seitenwand des Tragvorsprungs erstreckt sich ein halbkreisförmiger Grabenabschnitt. Die zur Nischenwandung weisende Wand des Tragvorsprungs verläuft bevorzugt auf einer Halbkreisbogenlinie. Eine dieser Wand des Tragvorsprungs gegenüberliegende Wand des Tragvorsprungs verläuft ebenfalls auf einer Halbkreisbogenlinie, so dass der Tragvorsprung einen im Wesentlichen ovalen Grundriss besitzt. Die in einer Parallelebene zum Boden des Lagerplatzes verlaufende Auflagefläche des Tragvorsprungs wird von der Umrisskonturlinie geschnitten. Die bevorzugt kreisförmige Umrisskonturlinie läuft somit über die Auflagefläche des Tragvorsprungs hinweg. Da sich der Rand des bevorzugt kreisrunden Substrates nur geringfügig radial innerhalb der Umrisskonturlinie des Lagerplatzes erstreckt, läuft auch die Randkante des Substrates über die Auflagefläche des Tragvorsprungs. Der Graben, der den Tragvorsprung umgibt, besitzt einen Boden, der in einer Ebene verläuft. Es handelt sich um eine Parallelebene zum Boden des Lagerplatzes beziehungsweise um eine Parallelebene zur Auflagefläche. Der Graben erstreckt sich mit einem einheitlichen Bodenniveau entlang der beiden die Nische flankierenden Positionierflanken. Der Graben besitzt somit zwei voneinander wegweisende längliche Abschnitte, die sich nahezu über die gesamte Länge der Positionierflanken erstrecken. Auch diese Maßnahme trägt zur Verminderung des Wärmetransportes von den Positionierflanken zum Substrat bei. Die Positionierflanken erstrecken sich bevorzugt nicht exakt entlang der Umrisskonturlinie des Lagerplatzes, also einer Kreisbogenlinie. Die Positionierflanken können leicht divergierend verlaufen; sie besitzen einen Abstand zur Umrisskonturlinie. Die beiden Übergangsbereiche der Nische zur Positionierflanke sollen bevorzugt auf der Umrisskonturlinie liegen. Die Grundfläche des Lagerplatzes ist gegenüber der Bodenfläche des Grabens vertikal beabstandet. Die Auflagefläche des Tragvorsprungs ist gegenüber der Fläche des Lagerplatzes beabstandet, so dass das Substrat hohl liegt.

Auf der Unterseite des Substrathalters befinden sich kreisförmige Vertiefungen, die um den Mittelpunkt der kreisförmigen Lagerplätze zentriert sind. Ein Randbereich der Vertiefung hat einen Boden, der sich auf einem ersten Vertiefungsniveau erstreckt. Ein Zentralbereich der Vertiefung hat einen Boden, der sich auf einem tieferen Niveau erstreckt.

### Kurze Beschreibung der Zeichnungen

Ausführungsbeispiele der Offenbarung werden nachfolgend anhand beigefügter Zeichnungen erläutert. Lediglich das zweite, dritte und vierte Ausführungsbeispiel sind erfindungsgemäß. Es zeigen:

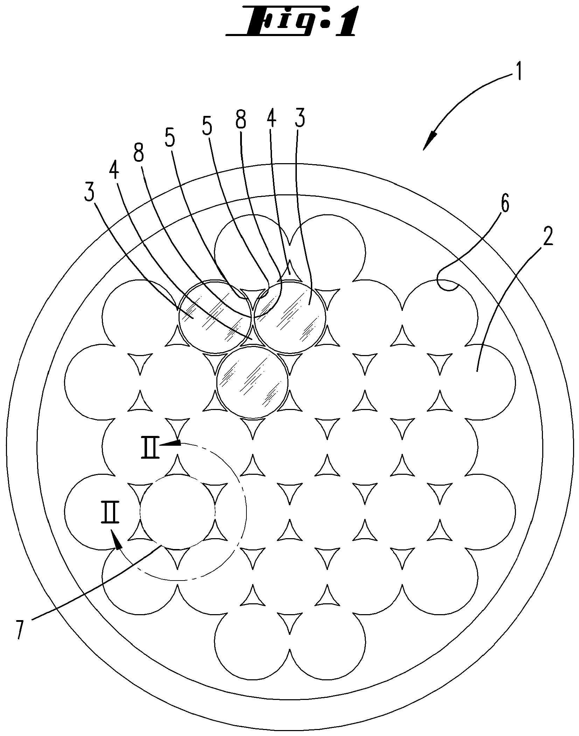

- Fig. 1: in der Draufsicht einen Substrathalter 1,
- Fig. 2: den Ausschnitt II-II in Figur 1,
- Fig. 3: eine Rückseitenansicht des Ausschnittes gemäß Figur 2,
- Fig. 4: den vergrößerten Ausschnitt IV-IV in Figur 2,
- Fig. 5: eine Perspektive des Ausschnitts gemäß Figur 4,
- Fig. 6: den Schnitt gemäß der Linie VI-VI in Figur 2,
- Fig. 7: den vergrößerten Ausschnitt VII-VII in Figur 6,
- Fig. 8: eine Darstellung gemäß Figur 2 eines zweiten Ausführungsbeispiels,
- Fig. 9: den Schnitt gemäß der Linie IX-IX in Figur 8,
- Fig. 10: vergrößert das Detail X in Figur 9,
- Fig. 11: vergrößert den Ausschnitt XI-XI in Figur 8,
- Fig. 12: vergrößert den Ausschnitt XII-XII in Figur 8,
- Fig. 13: ein drittes Ausführungsbeispiel der Erfindung in einer Darstellung gemäß Figur 4 und
- Fig. 14: ein viertes Ausführungsbeispiel der Erfindung.

### Beschreibung der Ausführungsformen

Der in den Zeichnungen dargestellte Substrathalter 1 findet als Suszeptor Verwendung in einem CVD-Reaktor. Ein CVD-Reaktor besitzt ein gasdicht nach außen geschlossenes Gehäuse, wie es schematisch in der DE 10 2011 055 061 A1 dargestellt ist. Innerhalb des Gehäuses befindet sich auf einem unteren Höhenniveau eine Heizung, bei der es sich um eine Widerstandsheizung handeln kann. Mit dieser Heizung wird der oberhalb der Heizung angeordnete Suszeptor 1 auf eine Oberflächentemperatur gebracht. Auf der Oberseite des Suszeptors 1 befindet sich eine Vielzahl von Lagerplätzen 2 jeweils zur Lagerung eines kreisscheibenförmigen Substrates. Jeder Lagerplatz 2 wird von insgesamt sechs in etwa dreieckigen Sockeln 4 eingefasst. Jeder Sockel kann drei einzelne Positionierflanken 5 oder drei Paare von Positionierflanken 5, 5' ausbilden. Es entsteht somit eine hexagonale Anordnung von kreisförmigen Lagerplätzen 2 jeweils zur Aufnahme eines Substrates 3, dessen Rand 8 entlang der Umrisskonturlinie 7 des jeweiligen Lagerplatzes 2 verläuft. Entlang jeder Umrisskonturlinie 7 erstrecken sich somit insgesamt sechs Einzelpositionierflanken 5 oder sechs Paare von Positionierflanken 5, 5', die jeweils von einem anderen Sockel 4 ausgebildet sind. Am Rand des Suszeptors 1 (Substrathalter) verlaufen längere kreisbogenförmige Positionierflanken 6. Die Umrisskonturlinie 7, die auf einer Kreisbogenlinie verläuft, schließt einen Lagerplatz zur Auflage eines kreisförmigen Substrates 3 ein. In den Ausführungsführungsbeispielen folgen die Positionierflanken 5, 5' nicht genau dem Verlauf der Umrisskonturlinie 7. Die Umrisskonturlinie 7 berührt jede der Positionierflanken 5, 5' im Wesentlichen nur an einer Tangentialstelle.

Oberhalb der mit Substraten 3 belegten Oberseite des Suszeptors 1 erstreckt sich die Prozesskammer, deren Höhe geringer ist, als der Durchmesser eines Substrates 3 und viel geringer ist, als der Durchmesser des kreisförmigen Suszeptors 1. Während der Suszeptor 1 einen Durchmesser von 30 cm und mehr besitzt, beträgt die Höhe der Prozesskammer nur 1 bis 5 cm.

Die Decke der Prozesskammer wird von einem Gaseinlassorgan ausgebildet, welches die Form eines Showerheads besitzt. Das Gaseinlassorgan besitzt eine gekühlte, zur Prozesskammer weisende Gasaustrittsfläche mit einer Vielzahl siebartig angeordneter Gasaustrittsöffnungen, durch die Prozessgase in die Prozesskammer strömen. Zur Vermeidung einer pyrolytischen Vorzerlegung der Prozessgase wird die Gasaustrittsfläche des Gaseinlassorganes aktiv gekühlt. Dies führt zu einem hohen vertikalen Temperaturgradienten in der Prozesskammer und damit zu einem hohen Wärmefluss von der beheizten Oberfläche des Suszeptors 1 zur gekühlten Gasaustrittsfläche. Die über diese Wärmeübertragungsstrecke abfließende Wärme muss von der Heizeinrichtung ständig nachgeliefert werden. Dies führt auch zu einem hohen vertikalen Temperaturgradienten innerhalb des Suszeptors 1. Da die Sockel 4, die die Positionierflanken 5, 5' ausbilden, körperlich mit dem Suszeptor 1 eine Einheit bilden und sich über Festkörperwärmeleitung aufheizen, besteht die Tendenz, dass über den Spalt zwischen Positionierflanke 5, 5' und Rand 8 des Substrates 3 ein unerwünschter Wärmefluss zum Substrat entsteht.

Das Substrat 3 liegt mit insgesamt sechs Stellen seines Randes 8 auf Tragvorsprüngen 9 auf, die der Oberseite des Suszeptors 1 entspringen. Das Substrat liegt somit hohl über der Lagerplatzbodenfläche 14 des Lagerplatzes 2. Die Wärmeübertragung vom Suszeptor 1 zum Substrat 3 erfolgt somit im Wesentlichen über Wärmestrahlung oder Konvektion von der Lagerplatzbodenfläche 14 des Lagerplatzes 2 zur Unterseite des Substrates 3. Nur im Bereich der Tragvorsprünge 9, wo die Randkante des Randes 8 des Substrates 3 auf den Auflageflächen 15 der Tragvorsprünge 9 aufliegt, erfolgt eine Kontakt-Wärmeübertragung durch die Festkörper-Wärmeleitung.

Erfindungsgemäß sind die Positionierflanken 5, 5' von dem Tragvorsprung 9 in lateraler Richtung und insbesondere in Richtung der Umrisskonturlinie 7, entlang welcher sich die Positionierflanken 5, 5' erstrecken, beabstandet.

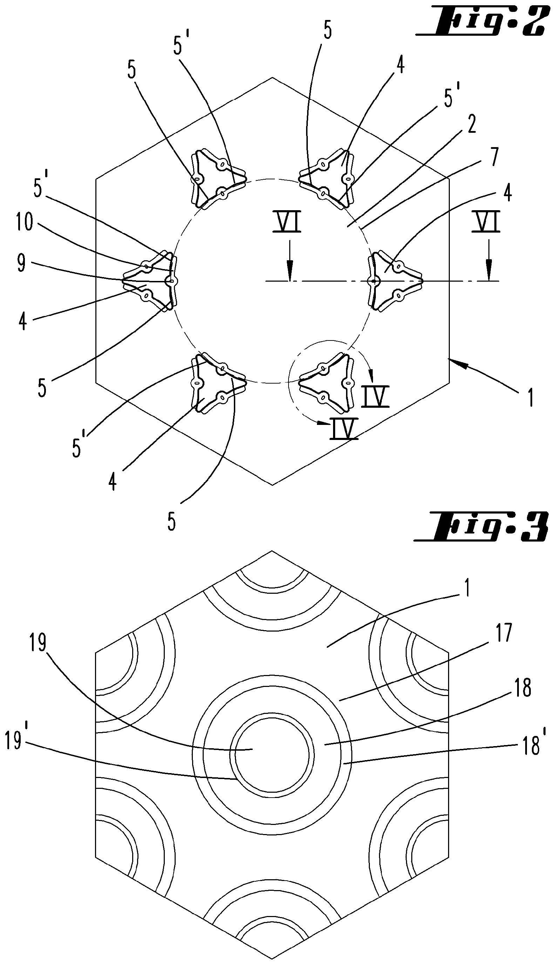

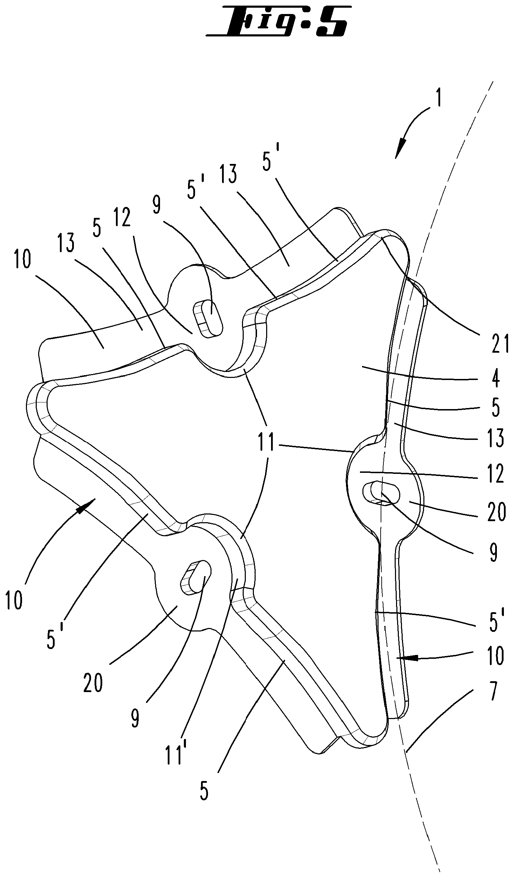

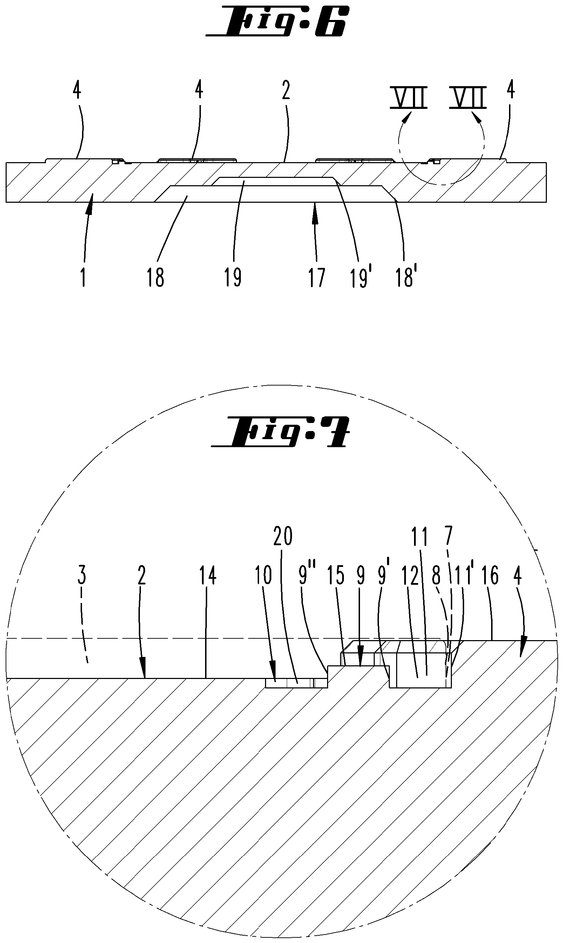

Zwei Positionierflanken 5, 5'können zusammen eine konkav gerundete Dreieckseite des Sockels 4 bilden. Die gerundete Dreieckseite des Sockels 4 kann aber auch von lediglich einer Positionierflanke 5 gebildet sein. Der Krümmungsradius der Positionierflanken 5, 5' ist aber geringfügig größer, als der Krümmungsradius der Umrisskonturlinie 7. Bei dem in den Figuren 2 bis 7 dargestellten Ausführungsbeispiel befindet sich in der Mitte der konkav gerundeten Dreieckseite eine Nische 11 mit einem auf einem Halbkreisbogen verlaufenden Rand. Der Mittelpunkt des den Halbkreisbogen definierenden Kreises liegt im Tragvorsprung 9. Dieser erstreckt sich von der Fläche des Lagerplatzes 2 über die Umrisskonturlinie 7 bis in die Nische 11 hinein. Die zur Nische weisende Wandung 9' des Tragvorsprungs 9 verläuft auf einer Kreisbogenlinie. Die davon wegweisende Wandung 9" verläuft ebenfalls auf einer Halbkreisbogenlinie. Die sich senkrecht zur Sockelstirnfläche 16 erstreckende Wand 11' verläuft auf einer Halbkreisbogenlinie und geht in die sich ebenfalls senkrecht zur Sockelstirnfläche 16 erstreckenden Positionierflanken 5, 5' über.

Der Tragvorsprung 9 besitzt senkrecht zur Auflagefläche 15 verlaufende Wandungen. Der Tragvorsprung 9 erhält somit eine zylinderförmige Gestalt, mit einer etwa ovalen Zylindergrundfläche. Der zylindrische Tragvorsprung 9 entspringt dem Boden eines Grabens 10, der den Tragvorsprung 9 ringsherum umgibt. Der Graben 10 bildet einen halbkreisförmigen Grabenabschnitt 12 aus, der den Boden der Nische 11 ausbildet. Ein weiterer halbkreisförmiger Grabenabschnitt 20 erstreckt sich jenseits des Tragvorsprungs 9, so dass die beiden jeweils halbkreisförmigen Grabenabschnitte 12, 20 zusammen einen ringförmig ovalen Grabenabschnitt ausbilden. Der eine Ausbuchtung ausbildende Grabenabschnitt 20 erstreckt sich in Radialrichtung zum Zentrum des Lagerplatzes 2. Die beiden Grabenabschnitte 12, 20 bilden eine einheitliche Vertiefung, die den Tragvorsprung 9 rings herum umgibt.

Der den Tragvorsprung 9 unmittelbar umgebende Grabenabschnitt 12, 20 grenzt an zwei längliche Grabenabschnitte 13 an, die sich entlang der Positionierflanken 5, 5' erstrecken. Die Positionierflanken 5, 5' entspringen somit dem Boden der länglichen Grabenabschnitte 13. Die länglichen Grabenabschnitte 13 erstrecken sich bis zu einem gerundeten Eckabschnitt 21 des Sockels 4.

Die Nische 11 besitzt eine Nischenwandung 11', die sich unter Ausbildung einer Rundung in jeweils eine der beiden Positionierflanken 5, 5' fortsetzt. Im Bereich dieser Übergangsrundungen tangiert die Umrisskonturlinie 7 die Positionierflanke 5, 5'. Mit zunehmender Entfernung von der Nische 11 entfernt sich die Positionierflanke 5, 5' von der Umrisskonturlinie 7. Die Wandung 11' der Nische 11 und die Positionierflanken 5, 5' verlaufen senkrecht zur Lagerplatzbodenfläche 14 beziehungsweise zu den Bodenflächen des Grabens 10 oder zur Sockelstirnfläche 16. Die Positionierflanken 5, 5' und die Nischenwand 11' gehen unter Ausbildung einer Fase in die Sockelstirnfläche 16 über. Die Auflageflächen 15 des Tragvorsprungs 9 überragt die Lagerplatzbodenfläche 14 um etwas mehr als die Tiefe des Grabens 10 gemessen von der Lagerplatzbodenfläche 14. Der Sockel 4 besitzt eine dreizählige Symmetrie und drei etwa entlang einer Bogenlinie verlaufende Positionierflanken 5, 5', die in ihrer Mitte von einer Nische 11 unterbrochen sind, wobei die Nische 11 eine etwa halbkreisförmige Einbuchtung in den Sockel 4 ausbildet. Die Ecken der Sockel 4 sind verrundet.

Auf der Unterseite des Suszeptors 1 befindet sich eine Vielzahl von kreisförmigen Ausnehmungen. Es handelt sich um Vertiefungen 17, die zum Zentrum des Lagerplatzes 2 zentriert sind. Ein zentraler tiefster Vertiefungsabschnitt 19 geht unter Ausbildung einer schräg verlaufenden Randflanke 19' in einen Randbereich 18 der Vertiefung 17 über, der wiederum unter Ausbildung eines schrägen Randabschnittes 18' in die Unterseitenfläche des Suszeptors 1 übergeht.

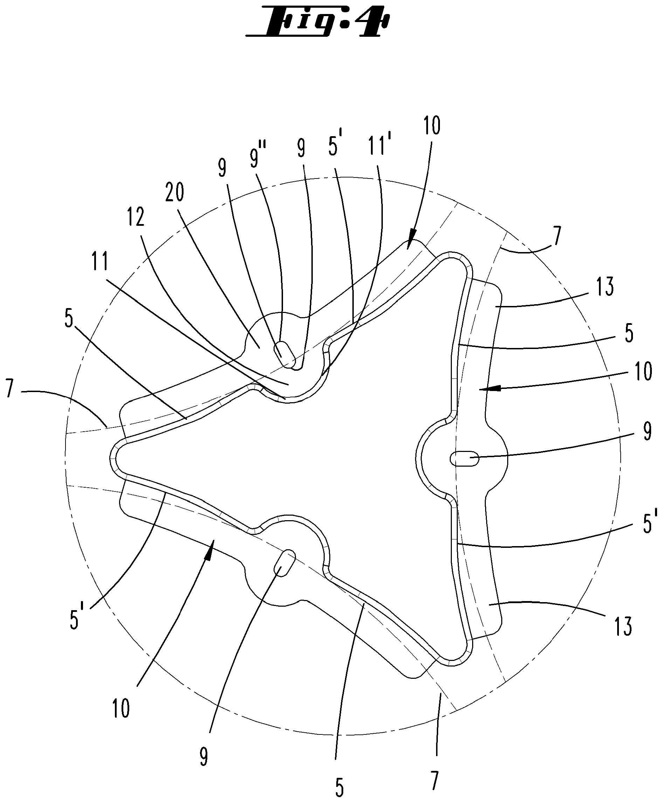

Bei dem in den Figuren 4 bis 7 dargestellten Tragvorsprüngen 9 hat die den Tragvorsprung 9 ringsumgebende Vertiefung 12, 20 einen ebenen, auf einem einheitlichen Vertiefungsniveau verlaufenden Boden. Der ebene Boden geht in die länglichen Grabenabschnitte 13 über. Die Auflagefläche 15 liegt in einem Substratauflageniveau und ist von dem Vertiefungsniveau in einer Vertikalrichtung weiter beabstandet, als von einem Bodenflächenniveau, in dem sich die Lagerplatzbodenfläche 14 erstreckt, die unter Ausbildung einer Stufe in den Graben 10 beziehungsweise die Vertiefung 12, 20 übergeht.

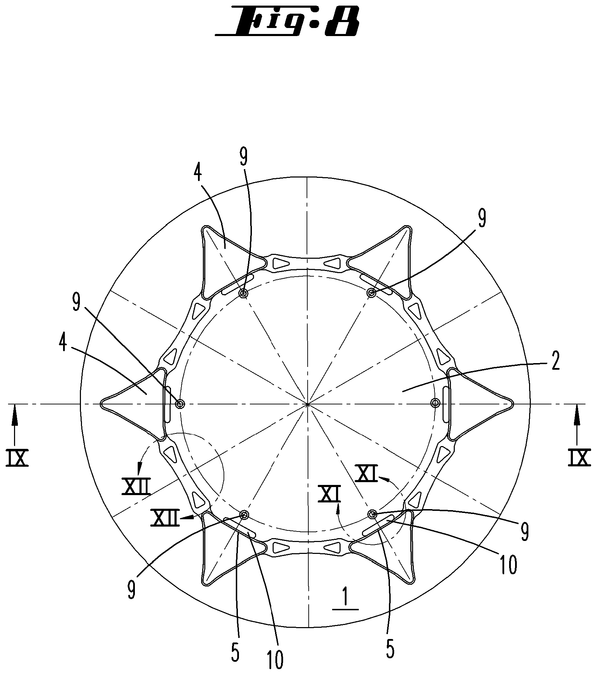

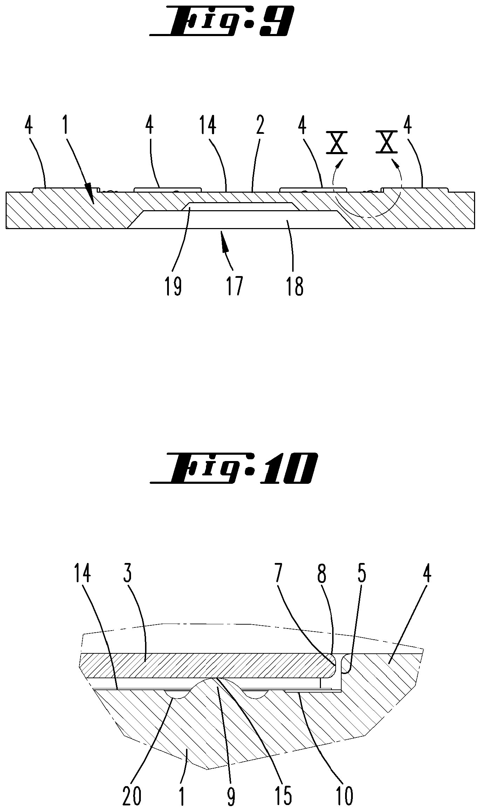

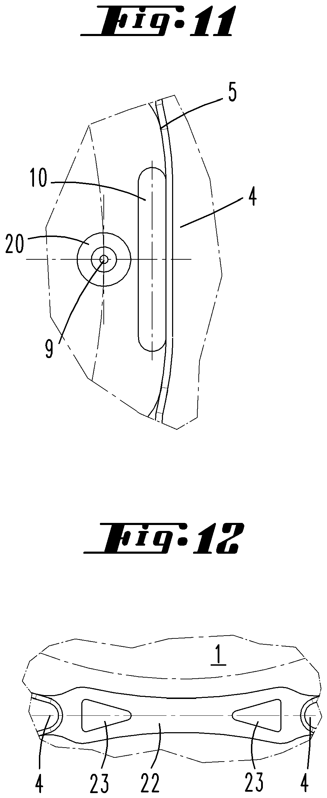

Die Figuren 8 bis 12 zeigen ein zweites Ausführungsbeispiel der Erfindung. Die Sockel 4 besitzen auch hier drei gleich gestaltete Seitenflanken, die jeweils Positionierflanken 5 ausbilden. Entlang der bevorzugt nicht von einer Nische unterbrochenen Positionierflanke 5 erstreckt sich ein Graben 10, der von einer Materialausnehmung ausgebildet wird. Der Graben 10 hat eine längliche gestalt und erstreckt sich lediglich über den mittleren Bereich der Positionierflanke 5. Die Ecken der Sockel 4 verlaufen auf Kreisbogenlinien. Zwischen den Ecken zweier benachbarter Sockel 4 sind Ausnehmungen 22 vorgesehen.

Die Umrisskonturlinie 7 ist eine Kreisbogenlinie. Die Umrisskonturlinie 7 umgrenzt eine Fläche, die von einem von den Tragvorsprüngen 9 getragenen Substrat 3 eingenommen wird. Der Rand 8 des Substrates verläuft auf der Umrisskonturlinie 7.

Die Tragvorsprünge 9 liegen gegenüber den Gräben 10 in Richtung des Zentrums der Umrisskonturlinie 7, also dem Flächenzentrum des Substrates 3 versetzt entfernt vom Graben 10. Die Tragvorsprünge liegen etwa auf Höhe der Mitte der Gräben 10.

Jeder der insgesamt sechs Tragvorsprünge 9 eines jeden Lagerplatzes 2 ist von einer kreisförmigen Vertiefung 20 umgeben. Die Breite der ringförmigen Vertiefung 20 entspricht in etwa dem Durchmesser des im Wesentlichen einen kreisrunden Grundriss aufweisenden Tragvorsprungs 9. Der Rand der Vertiefung 20 befindet sich in der Lagerplatzbodenfläche 14, die sich in einem Bodenflächenniveau erstreckt, welches unterhalb eines Substratauflageniveaus verläuft, in welchem die Auflageflächen 15 der Tragvorsprünge 9 liegen. Die Bodenfläche der Vertiefung 20, die bei dem in den Figuren 8 bis 12 dargestellten Ausführungsbeispiel von einer Scheitellinie ausgebildet ist, verläuft auf einem Bodenflächenniveau, welches einen größeren Abstand zum Substratauflageniveau besitzt, als das Bodenflächenniveau.

Die Vertiefung 20 besitzt einen gerundeten Boden. Der Querschnitt des Bodens beschreibt in etwa einen Halbkreis, so dass die Vertiefung 20 als den Tragvorsprung 9 umgebende Rinne ausgebildet ist. Die Seitenwandung des Tragvorsprungs 9 geht knickstellenfrei aus der Wandung der Vertiefung 20 in die Auflagefläche 15 über, die eine Kreisfläche ist, die sich in einer Parallelebene zur Lagerplatzbodenfläche 14 erstreckt.

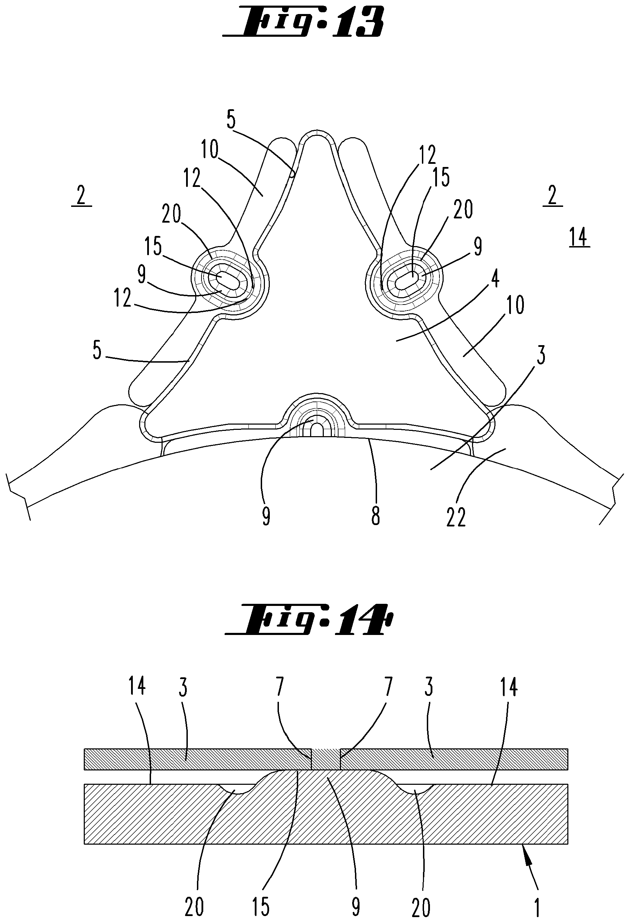

Bei dem in der Figur 13 dargestellten dritten Ausführungsbeispiel befindet sich die Vertiefung 20 wie beim ersten Ausführungsbeispiel im Bereich eines Grabens 10 und erstreckt sich bis in eine Nische 11 zwischen zwei Positionierflanken 5, 5'. Anders als beim ersten Ausführungsbeispiel verläuft hier die Bodenfläche der Vertiefung 20,12, die den Tragvorsprung 9 ringförmig umgibt, nicht in einer Ebene, sondern besitzt gerundete Wände, die in eine ovale Scheitellinie oder Scheitelfläche übergehen. Die äußere Wandung der Vertiefung 20, 12 kann unter Ausbildung einer Kante, aber auch in erfindungsgemäßer Art und Weise unter Ausbildung einer Verrundung in die Lagerplatzbodenfläche 14 übergehen.

Der Rand 8 des Substrates 3, der auf der Umrisskonturlinie 7 verläuft, kreuzt die Auflagefläche 15.

Das in den Figuren 8 bis 12 dargestellte zweite Ausführungsbeispiel besitzt zwischen den Eckbereichen der Sockel 4 längliche Vertiefungen 22, die sich bereichsweise unterhalb der Umrisskonturlinie 7 erstrecken. Dort können auch zusätzliche Vertiefungen 23 angeordnet sein, so dass sich die zwischen den Eckbereichen der Sockel 4 erstreckende Vertiefung zwei verschiedene Niveaus besitzt.

Das in der Figur 14 dargestellte vierte Ausführungsbeispiel zeigt einen Tragvorsprung 9, der in einem Bereich zwischen den Ecken der Sockel 4 angeordnet sein kann. Dieser ovale Tragvorsprung 9 besitzt eine Auflagefläche 15, die von zwei Umrisskonturlinien 7 benachbarter Lagerplätze 2 gekreuzt werden kann. Die Auflagefläche 15 des Tragvorsprungs 9 ist somit in der Lage, die Ränder zweier Substrate 3 zu tragen. Auch bei diesem Ausführungsbeispiel sind die seitlichen Wände des Tragvorsprungs 9 und der Vertiefung 20, der der Tragvorsprung 9 entspringt, gerundet. Der Figur 14 ist zu entnehmen, dass der Außenrand der Vertiefung 20 von einer Rundung ausgebildet ist, die knickstellenfrei in eine den Scheitelbereich der Vertiefung 20 ausbildende Rundung übergeht. Diese Rundung geht in eine entgegengesetzt gekrümmte Rundung über, die den oberen Seitenwandbereich des Tragvorsprungs 9 ausbildet. Letztere Rundung geht knickstellenfrei in die Auflagefläche 15 über.

### Liste der Bezugszeichen

- 1: Substrathalter
- 2: Lagerplatz
- 3: Substrat
- 4: Sockel
- 5: Positionierflanke
- 5': Positionierflanke
- 6: Positionierflanke
- 7: Umrisskonturlinie
- 8: Rand der Substrate
- 9: Tragvorsprung
- 10: Graben
- 11: Nische
- 11': Wand, Seitenwand
- 12: Grabenabschnitt
- 13: Grabenabschnitt
- 14: Lagerplatzbodenfläche
- 15: Auflagefläche
- 16: Sockelstirnfläche
- 17: Vertiefung
- 18: Randbereich
- 18': Randflanke
- 19: Vertiefungsabschnitt
- 19': Randflanke
- 20: Grabenabschnitt/Vertiefung
- 21: Eckabschnitt
- 22: Ausnehmung
- 23: Ausnehmung

## Patentansprüche

1. Vorrichtung zur Halterung mindestens eines Substrates zur Verwendung in einer Prozesskammer eines CVD- oder PVD-Reaktors, mit einer flachen Oberseite, auf der sich zumindest ein Lagerplatz (2) für das mindestens eine Substrat (3) befindet, wobei eine der Umrisskontur des Substrates (3) entsprechende Umrisskonturlinie (7) von Positionierflanken (5, 5') zur lagefixierenden Anlage jeweils eines Abschnitts des Randes (8) des Substrates (3) flankiert ist, die eine sich auf einem Bodenflächenniveau erstreckende Lagerplatzbodenfläche (14) umgibt, mit jeweils aus einer Vertiefung (20) der Lagerplatzbodenfläche (14) entspringenden Tragvorsprüngen (9), die gegenüber der Lagerplatzbodenfläche (14) erhabene Anlageflächen (15) aufweisen, auf die das Substrat (3) in einem Substratauflageniveau, in dem sich die Auflageflächen (15) erstrecken, auflegbar ist, wobei jeweils ein Tragvorsprung (9) von der ein Vertiefungsniveau aufweisenden Vertiefung (20) ringsumgeben ist, das vom Substratauflageniveau in Vertikalrichtung weiter entfernt ist, als das Bodenflächenniveau, wobei die Vertiefung (20) eine im Vertiefungsniveau liegende ringförmige Scheitellinie aufweist, von der der Boden der Vertiefung (20) unter Ausbildung einer Querschnittsverrundung in die Außenwand des Tragvorsprung (9) übergeht, welche wiederum knickstellenfrei unter Ausbildung einer Querschnittsverrundung in die gewölbte Auflagefläche (15) übergeht, **dadurch gekennzeichnet, dass** sich der Tragvorsprung (9) in der Art einer Auswölbung knickstellenfrei von der Scheitellinie bis hin zur Auflagefläche (15) erstreckt.

2. Vorrichtung nach Anspruch 1, **dadurch gekennzeichnet, dass** der Tragvorsprung (9) und der Rand der den Tragvorsprung (9) umgebenden Vertiefung (20) innerhalb des von der Umrisskonturlinie (7) eingefassten Lagerplatz (2) liegt, oder dass die Umrisskonturlinie (7) die Auflagefläche (15) kreuzt.

3. Vorrichtung nach einem der vorhergehenden Ansprüche, **gekennzeichnet durch** eine entlang der Positionierflanken (5, 5') verlaufende, einen Graben (10) ausbildende Ausnehmung der Lagerplatzbodenfläche (14).

4. Vorrichtung nach einem der vorhergehenden Ansprüche, **dadurch gekennzeichnet, dass** die Vertiefung (20) ein Abschnitt des Grabens (10) ist.

5. Vorrichtung nach einem der vorhergehenden Ansprüche, **gekennzeichnet durch** eine zwischen zwei benachbarten Positionierflanken (5, 5') angeordnete Nische (11).

6. Vorrichtung nach Anspruch 5, **dadurch gekennzeichnet, dass** sich zwischen einer Seitenwand (11') der Nische (11) und einer Seitenwand (9') des Tragvorsprungs (9) ein Grabenabschnitt (12) erstreckt.

7. Vorrichtung nach einem der Ansprüche 5 oder 6, **dadurch gekennzeichnet, dass** die Nische (11) in der Draufsicht halbkreisförmig ist.

8. Vorrichtung nach einem der vorhergehenden Ansprüche, **dadurch gekennzeichnet, dass** der Tragvorsprung (9) zwei sich gegenüberliegende halbkreisförmige Seitenwände (9', 9") aufweist.

9. Vorrichtung nach einem der vorhergehenden Ansprüche, **dadurch gekennzeichnet, dass** der Tragvorsprung (9) zwischen zwei benachbarten Sockeln (4) liegt und eine Auflagefläche (15) aufweist, über die zwei Umrisskonturlinien (7) hinweglaufen.

10. Vorrichtung nach Anspruch 9, **dadurch gekennzeichnet, dass** sich eine langgestreckte Vertiefung (22) zwischen zwei benachbarten Sockeln (4) erstreckt.

## Claims

1. A device for holding at least one substrate for use in a process chamber of a CVD or PVD reactor, with a flat upper side on which at least one bearing area (2) for the at least one substrate (3) is located, wherein an outline contour line (7) corresponding to the outline contour of the substrate (3) is flanked by positioning flanks (5, 5') for the positionally fixed contacting of a respective section of an edge (8) of the substrate (3), which surrounds a bearing area base surface (14) extending on a base surface level, with respective carrying protrusions (9) projecting from a depression (20) of the bearing area base surface (14), which have contact surfaces (15) that are raised in relation to the bearing area base surface (14), on which the substrate (3) can be placed, in a substrate contact level in which the contact surfaces (15) extend, wherein a respective carrying protrusion (9) is completely surrounded by a depression (20) exhibiting a depression level, which is spaced farther apart from the substrate contact level in a vertical direction than the base surface level, wherein the depression (20) has an annular apex line lying in the depression level, from which the floor of the depression (20) transitions into the outer wall of the carrying protrusion (9) with the formation of a cross sectional rounding, which in turn transitions without kinks into the curved contact surface (15) with the formation of a cross sectional rounding, **characterized in that** the carrying protrusion (9) extends as a kind of bulge without kinks from the apex line up to the contact surface (15).

2. The device according to claim 1, **characterized in that** the carrying protrusion (9) and the edge of the depression (20) surrounding the carrying protrusion (9) lie inside of the bearing area (2) bordered by the outline contour line (7), or that the outline contour line (7) crosses the contact surface (15).

3. The device according to one of the preceding claims, **characterized by** a recess in the bearing area base surface (14) that runs along the positioning flanks (5, 5') and forms a trench (10).

4. The device according to one of the preceding claims, **characterized in that** the depression (20) is a section of the trench (10).

5. The device according to one of the preceding claims, **characterized by** a niche (11) situated between two adjacent positioning flanks (5, 5').

6. The device according to claim 5, **characterized in that** a trench section (12) extends between a lateral wall (11') of the niche (11) and a lateral wall (9') of the carrying protrusion (9).

7. The device according to one of the claims 5 or 6, **characterized in that** the niche (11) is semicircular as viewed from the top.

8. The device according to one of the preceding claims, **characterized in that** the carrying protrusion (9) has two opposing semicircular lateral walls (9', 9").

9. The device according to one of the preceding claims, **characterized in that** the carrying protrusion (9) lies between two adjacent sockets (4), and exhibits a contact surface (15) over which the two outline contour lines (7) run.

10. The device according to claim 9, **characterized in that** an oblong depression (22) extends between two adjacent sockets (4).

## Revendications

1. Dispositif pour maintenir au moins un substrat destiné à être utilisé dans une chambre de traitement d'un réacteur CVD ou PVD, comprenant une face supérieure plane sur laquelle se trouve au moins un emplacement de posage (2) pour l'au moins un substrat (3), dans lequel une ligne de contour (7) correspondant au contour du substrat (3) est flanquée de flancs de positionnement (5, 5') pour la mise en appui avec fixation en position d'une partie respective du bord (8) du substrat (3) et entoure une surface de base d'emplacement de posage (14) qui s'étend à un niveau de surface de base, et comprenant des saillies de support (9) qui partent chacune d'un renfoncement (20) de la surface de base d'emplacement de posage (14) et qui présentent des surfaces d'appui (15) surélevées par rapport à la surface de base d'emplacement de posage (14) sur lesquelles le substrat (3) peut être posé à un niveau d'appui de substrat auquel s'étendent les surfaces d'appui (15), dans lequel une saillie de support (9) est à chaque fois entourée de manière annulaire par le renfoncement (20) présentant un niveau de renfoncement qui est plus éloigné du niveau d'appui de substrat dans la direction verticale que le niveau de surface de base, dans lequel le renfoncement (20) présente une ligne de sommet annulaire située au niveau de renfoncement à partir de laquelle le fond du renfoncement (20) se prolonge dans la paroi extérieure de la saillie de support (9) en formant un arrondi en section transversale, qui à son tour se prolonge sans pli dans la surface d'appui (15) bombée en formant un arrondi en section transversale, **caractérisé en ce que** la saillie de support (9) s'étend de la ligne de sommet jusqu'à la surface d'appui (15) à la manière d'un bombement sans pli.

2. Dispositif selon la revendication 1, **caractérisé en ce que** la saillie de support (9) et le bord du renfoncement (20) entourant la saillie de support (9) se trouvent dans l'emplacement de posage (2) qui entouré par la ligne de contour (7), ou **en ce que** la ligne de contour (7) croise la surface d'appui (15).

3. Dispositif selon l'une des revendications précédentes, **caractérisé par** un évidement de la surface de base d'emplacement de posage (14) qui s'étend le long des flancs de positionnement (5, 5') et forme une tranchée (10).

4. Dispositif selon l'une des revendications précédentes, **caractérisé en ce que** le renfoncement (20) est une partie de la tranchée (10).

5. Dispositif selon l'une des revendications précédentes, **caractérisé par** une niche (11) agencée entre deux flancs de positionnement adjacents (5, 5').

6. Dispositif selon la revendication 5, **caractérisé en ce qu'**une partie de tranchée (12) s'étend entre une paroi latérale (11') de la niche (11) et une paroi latérale (9') de la saillie de support (9).

7. Dispositif selon l'une des revendications 5 ou 6, **caractérisé en ce que** la niche (11) est semi-circulaire en vue de dessus.

8. Dispositif selon l'une des revendications précédentes, **caractérisé en ce que** la saillie de support (9) présente deux parois latérales semi-circulaires (9, 9) se faisant face.

9. Dispositif selon l'une des revendications précédentes, **caractérisé en ce que** la saillie de support (9) se trouve entre deux socles (4) adjacents et présente une surface d'appui (15) sur laquelle passent deux lignes de contour (7).

10. Dispositif selon la revendication 9, **caractérisé en ce qu'**un renfoncement allongé (22) s'étend entre deux socles adjacents (4).
